(19) Europäisches Patentamt
European Patent Office
Office européen des brevets

(11) **EP 4 312 217 B1**

(12) **EUROPEAN PATENT SPECIFICATION**

(45) Date of publication and mention
of the grant of the patent:
**01.04.2026 Bulletin 2026/14**

(21) Application number: **23187131.0**

(22) Date of filing: **23.07.2023**

(51) International Patent Classification (IPC):
**G11C 7/10** *(2006.01)*     **G06N 3/02** *(2006.01)*
**G11C 11/54** *(2006.01)*     **G11C 27/02** *(2006.01)*
**G06N 3/0464** *(2023.01)*     **G06N 3/065** *(2023.01)*

(52) Cooperative Patent Classification (CPC):
**G11C 7/1006; G06N 3/0464; G06N 3/065;
G11C 11/54; G11C 27/02**

(54) **COMPUTE-IN-MEMORY CIRCUIT WITH CHARGE-DOMAIN PASSIVE SUMMATION AND
ASSOCIATED METHOD**

RECHEN-IN-SPEICHER-SCHALTUNG MIT PASSIVER LADUNGSDOMÄNENSUMMIERUNG UND
ZUGEHÖRIGES VERFAHREN

CIRCUIT DE CALCUL EN MÉMOIRE AVEC SOMMATION PASSIVE EN DOMAINE DE CHARGE ET
PROCÉDÉ ASSOCIÉ

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **28.07.2022 US 202263369673 P
28.07.2022 US 202263369674 P
28.06.2023 US 202318215175**

(43) Date of publication of application:
**31.01.2024 Bulletin 2024/05**

(73) Proprietor: **MediaTek Inc.
Hsin-Chu 300 (TW)**

(72) Inventor: **HSIEH, Sung-En
30078 Hsinchu City (TW)**

(74) Representative: **Haseltine Lake Kempner LLP
Cheapside House
138 Cheapside
London EC2V 6BJ (GB)**

(56) References cited:
**US-A1- 2022 012 016**

**Description**

This application claims the benefit of U.S. Provisional Application No. 63/369,673, filed on July 28th, 2022. Further, this application claims the benefit of U.S. Provisional Application No. 63/369,674, filed on July 28th, 2022.

Background

The present invention relates to a compute-in-memory (CIM) design, and more particularly, to a CIM circuit with charge-domain passive summation and an associated method.

A convolutional neural network (CNN) used by an artificial intelligence (AI) application is made up of neurons that have learnable weights. Each neuron receives AI inputs, and performs a dot product (i.e., a convolution operation) upon AI inputs and weights. One conventional approach may employ a central processing unit (CPU) to deal with the convolution operations, which is not a power-efficient solution. Another conventional approach may employ a bit-wise current-based or time-based compute-in-memory (CIM) circuit to deal with the convolution operations, which is neither a power-efficient solution nor a high-accuracy solution. Thus, there is a need for an innovative CIM design with low power consumption and high accuracy. US 2022/0012016 A1 discloses an in-memory multiply-accumulate (MAC) architecture that executes a MAC operation based on an analog input signal and digital signals to output an analog output signal based on the same.

Summary

One of the objectives of the claimed invention is to provide a CIM circuit with charge-domain passive summation and an associated method.

According to a first aspect of the present invention, there is provided a CIM circuit. The CIM circuit includes a first processing circuit. The first processing circuit includes a first data-selection circuit and a first charge-domain passive summation circuit. The first data-selection circuit includes a first memory array and a first selection circuit. The first memory array is arranged to store a plurality of candidate weights. The first selection circuit is arranged to select a first target weight from the plurality of candidate weights stored in the first memory array. The first charge-domain passive summation circuit is arranged to generate a first analog computation result of a first input received by the first processing circuit and the first target weight stored in the first memory array through a first weighted capacitor array integrated with the first memory array. The first weighted capacitor array of the first charge-domain passive summation circuit comprises a plurality of first capacitors. The first selection circuit is further arranged to output a plurality of voltage signals to the plurality of first capacitors, respectively, according to the first input and the first target weight.

According to a second aspect of the present invention, there is provided CIM method applied on a system as defined by the first aspect of the present invention. The CIM method includes: storing a plurality of candidate weights in a memory array; selecting a target weight from the plurality of candidate weights; and performing, by a weighted capacitor array integrated with the memory array, charge-domain passive summation to generate an analog computation result of an input and the target weight.

These and other objectives of the present invention will no doubt become obvious to those of ordinary skill in the art after reading the following detailed description of the preferred embodiment that is illustrated in the various figures and drawings.

Brief Description of the Drawings

FIG. 1 is a diagram illustrating a compute-in-memory (CIM) circuit according to an embodiment of the present invention.

FIG. 2 is a diagram illustrating a circuit design of a processing circuit used by the CIM circuit shown in FIG. 1 according to an embodiment of the present invention.

FIG. 3 is a diagram illustrating calibration of different external analog buffers of a CIM circuit according to an embodiment of the present invention.

FIG. 4 is a diagram illustrating inter-buffer mismatch between different external analog buffers.

FIG. 5 is a diagram illustrating additional calibration of different external analog buffers of a CIM circuit according to an embodiment of the present invention.

FIG. 6 is a diagram illustrating deviation between aligned transfer curves of different external analog buffers and an ideal curve before reference voltage tuning.

FIG. 7 is a diagram illustrating that the aligned transfer curves of different external analog buffers are the same as the ideal curve after reference voltage tuning.

FIG. 8 is a diagram illustrating per-layer calibration of different external analog buffers of a CIM circuit according to an embodiment of the present invention.

Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

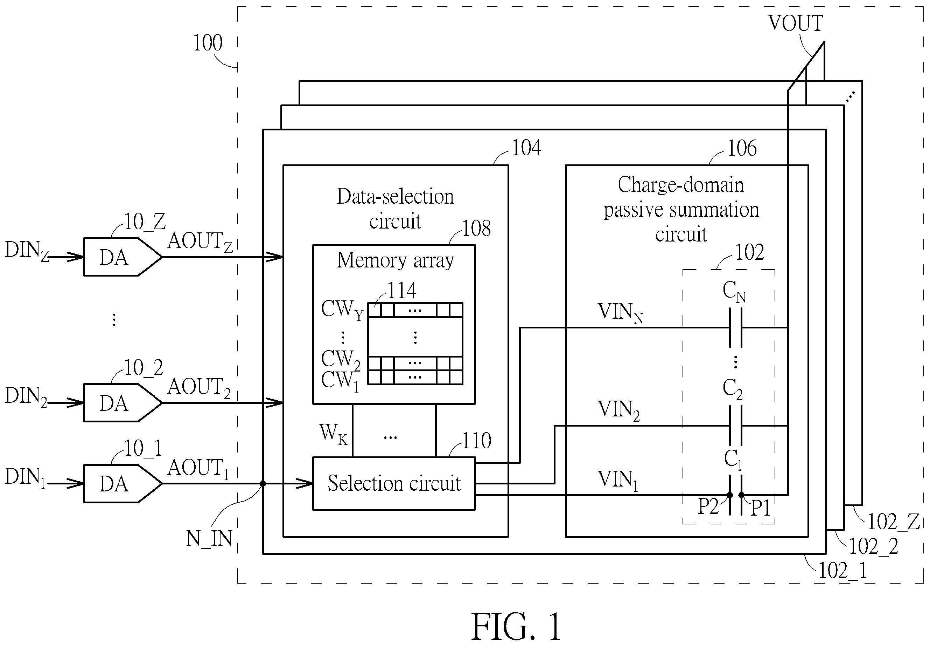

FIG. 1 is a diagram illustrating a CIM circuit according to an embodiment of the present invention. The CIM circuit 100 includes a plurality of processing circuits 102_1, 102_2, ..., 102_Z used to process a plurality of inputs, respectively. By way of example, but not limitation, the processing circuits 102_1-102_Z ($Z \geq 2$) may have the same circuit architecture. Taking the processing circuit 102_1 for example, it may include a data-selection circuit 104 and a charge-domain passive summation circuit 106. The data-selection circuit 104 may include a memory array 108 and a selection circuit 110. The charge-domain passive summation circuit 106 may include a weighted capacitor array 112. As shown in FIG. 1, the weighted capacitor array 112 includes a plurality of capacitors $C_1$, $C_2$, ..., $C_N$ with different capacitance values. The memory array 108 includes a plurality of memory cells 114, and is arranged to store a plurality of candidate weights $CW_1$, $CW_2$, ..., $CW_Y$. Each of the candidate weights $CW_1$-$CW_Y$ ($Y \geq 2$) may be an X-bit weight $CW_i$[X-1:0] ($i = \{1, 2, ..., Y\}$ & $X \geq 2$), and each bit of the X-bit weight $CW_i$[X-1:0] is stored in one memory cell 114 of the memory array 108. For example, the memory array 108 may be a static random access memory (SRAM) array, and each of the memory cells 114 may be an SRAM cell. However, this is for illustrative purposes only, and is not meant to be a limitation of the present invention. In practice, the memory type of the memory array 108 may be adjusted, depending upon actual design considerations.

It should be noted that the present invention has no limitations on the arrangement of word lines (WLs) and bit lines (BLs) of the memory array 108. In one exemplary implementation, the memory array 108 may be designed to have WLs in a horizontal direction and BLs in a vertical direction. In another exemplary implementation, the memory array 108 may be designed to have WLs in a vertical direction and BLs in a horizontal direction.

In some embodiments of the present invention, the CIM circuit 100 may be an analog CIM (ACIM) circuit used by an artificial intelligence (AI) application, and the candidate weights $CW_1$-$CW_Y$ may be weights of a neural network such as a convolutional neural network (CNN). The selection circuit 110 is arranged to select a target weight $W_k$ ($k = \{1, 2, ..., Z\}$) from the candidate weights $CW_1$-$CW_Y$ stored in the memory array 108. For example, the selection circuit 110 of the processing circuit 102_1 may select a target weight $W_1$ (i.e., $W_k$ with k = 1) being one of the candidate weights $CW_1$-$CW_Y$, the selection circuit 110 of another processing circuit 102_2 may select

a target weight $W_2$ (i.e., $W_k$ with k = 2) being one of the candidate weights $CW_1$-$CW_Y$, and the selection circuit 110 of yet another processing circuit 102_Z may select a target weight $W_Z$ (i.e., $W_k$ with k = Z) being one of the candidate weights $CW_1$-$CW_Y$. The target weights selected and used by different processing circuits 102_1-102_Z may be the same or may be different from each other. In a case where the CIM circuit 100 is used by an AI application, the CIM circuit 100 may be used to act as one neuron in the CNN, and may be reused to act as another neuron in the CNN. Hence, the candidate weights $CW_1$-$CW_Y$ may include weights of different neurons in the CNN.

In this embodiment, the CIM circuit 100 is an ACIM circuit that uses the charge-domain passive summation circuit 106 to generate an analog computation result of an analog input $AOUT_1$ (i.e., $AOUT_k$ with k = 1) received by the processing circuit 102_1 and the target weight $W_1$ (i.e., $W_k$ with k = 1, which is one of the candidate weights $CW_1$-$CW_Y$ stored in the memory array 108) through the weighted capacitor array 112 with a particular capacitance ratio, where the particular capacitance ratio may be adjusted, depending upon actual design considerations. For example, capacitors $C_1$-$C_N$ of the weighted capacitor array 112 may be implemented using MOM (Metal-Oxide-Metal) capacitors, and thus occupy a large layout area in a chip. In this embodiment, the weighted capacitor array 112 of the charge-domain passive summation circuit 106 can be shared among multiple candidate weights $CW_1$-$CW_Y$ stored in the memory array 108. Hence, the weighted capacitor array 112 can be integrated with the memory array 108 for area optimization. Specifically, in a vertical direction of an integrated circuit, the weighted capacitor array 112 implemented using MOM capacitors may overlay memory cells 114 of the memory array 108 that are used to store the candidate weights $CW_1$-$CW_Y$.

In this embodiment, the processing circuits 102_1-102_Z are arranged to receive a plurality of analog inputs $AOUT_1$, $AOUT_2$, ..., $AOUT_Z$ output from a plurality of external analog buffers 10_1, 10_2, ..., 10_Z, respectively. For example, each of the external analog buffers 10_1-10_Z may be implemented using a digital-to-analog converter (labeled by "DA"). Hence, the analog inputs $AOUT_1$, $AOUT_2$, ..., $AOUT_Z$ are generated by converting a plurality of digital codes $DIN_1$, $DIN_2$, ..., $DIN_Z$ from a digital domain to an analog domain. Since inputs of the processing circuits 102_1-102_Z are analog signals, node (energy) reduction can be achieved. For example, the processing circuit 102_1 requires only a single node N_IN for receiving only a single analog input $AOUT_1$ (which has a specific voltage level representative of the digital code $DIN_1$) from the external analog buffer 10_1, such that the input power dissipation ($fCV^2$) can be greatly reduced.

As mentioned above, each of the candidate weights $CW_1$-$CW_Y$ ($Y \geq 2$) may be an X-bit weight $CW_i$[X-1:0] ($i = \{1, 2, ..., Y\}$ & $X \geq 2$), and each bit of the X-bit

weight $CW_i[X-1:0]$ is stored in one memory cell 114 of the memory array 108. Hence, the target weight $W_1$ (i.e., $W_k$ with k = 1) has a plurality of bits $W_1[X-1:0]$ stored in memory cells 114 in the memory array 108, respectively. In this embodiment, the selection circuit 110 is further arranged to selectively apply the analog input $AOUT_1$ to capacitors $C_1$-$C_N$ according to bits $W_1[X-1:0]$, respectively. For example, the weighted capacitor array 112 is a binary-weighted capacitor array (N = X-1) consisting of capacitors $C_N = 2^{X-1}C$, ..., $C_2 = 2C$, and $C_1 = 1C$. When $W_1[i]$ ($i = \{1, 2, ..., X-1\}$) is equal to 1, the selection circuit 110 allows the analog input $AOUT_1$ to be delivered to a capacitor $C_i$ of the binary-weighted capacitor array 112 (i.e., $VIN_i = AOUT_1$). When $W_1[i]$ ($i = \{1, 2, ..., X-1\}$) is equal to 0, the selection circuit 110 blocks the analog input $AOUT_1$ from being delivered to the capacitor $C_i$ of the binary-weighted capacitor array 112, and allows a reference voltage (e.g., ground voltage GND) to be delivered to the capacitor $C_i$ of the binary-weighted capacitor array 112 (i.e., $VIN_i = GND$). In this embodiment, the selection circuit 110 is arranged to control transmission of the analog input $AOUT_1$ by referring to the bits $W_1[X-1:0]$ concurrently, thereby enabling a direct multi-bit operation for setting the analog computation result at the charge-domain passive summation circuit 106. Hence, the charge-domain passive summation circuit 106 (particularly, weighted capacitor array 112 of charge-domain passive summation circuit 106) of the processing circuit 102_1 generates an analog computation result (which is an analog output of $DIN_1 \times W_1[X-1:0]$) by combining the voltage signals $VIN_1$-$VIN_N$ through charge redistribution among the binary-weighted capacitor array $C_N = 2^{X-1}C$, ..., $C_2 = 2C$, and $C_1 = 1C$. Since the analog computation result is set by controlling voltage signals $VIN_1$-$VIN_N$ applied to capacitors $C_1$-$C_N$ of the weighted capacitor array 112 according to bits $W_1[X-1:0]$, the analog computation result with high accuracy can be generated from the processing circuit 102_1.

Similarly, the charge-domain passive summation circuit 106 (particularly, weighted capacitor array 112 of charge-domain passive summation circuit 106) of anther processing circuit 102_2 generates an analog computation result (which is an analog output of $DIN_2 \times W_2[X-1:0]$) by combining the voltage signals $VIN_1$-$VIN_N$ through charge redistribution among the binary-weighted capacitor array $C_N = 2^{X-1}C$, ..., $C_2 = 2C$, and $C_1 = 1C$; and the charge-domain passive summation circuit 106 (particularly, weighted capacitor array 112 of charge-domain passive summation circuit 106) of yet another processing circuit 102_Z generates an analog computation result (which is an analog output of $DIN_Z \times W_Z[X-1:0]$) by combining the voltage signals $VIN_1$-$VIN_N$ through charge redistribution among the binary-weighted capacitor array $C_N = 2^{X-1}C$, ..., $C_2 = 2C$, and $C_1 = 1C$.

As shown in FIG. 1, each of the capacitors $C_1$-$C_N$ has a top plate P1 and a bottom plate P2, and top plates P1 of capacitors $C_1$-$C_N$ included in the weighted capacitor arrays 112 of all processing circuits 102_1-102_Z are directly connected without selection. The output voltage VOUT (which is an analog output of

$$\sum_{k=1}^{Z} DIN_k \times W_k[X-1:0]$$

) can be obtained by means of such a simple design.

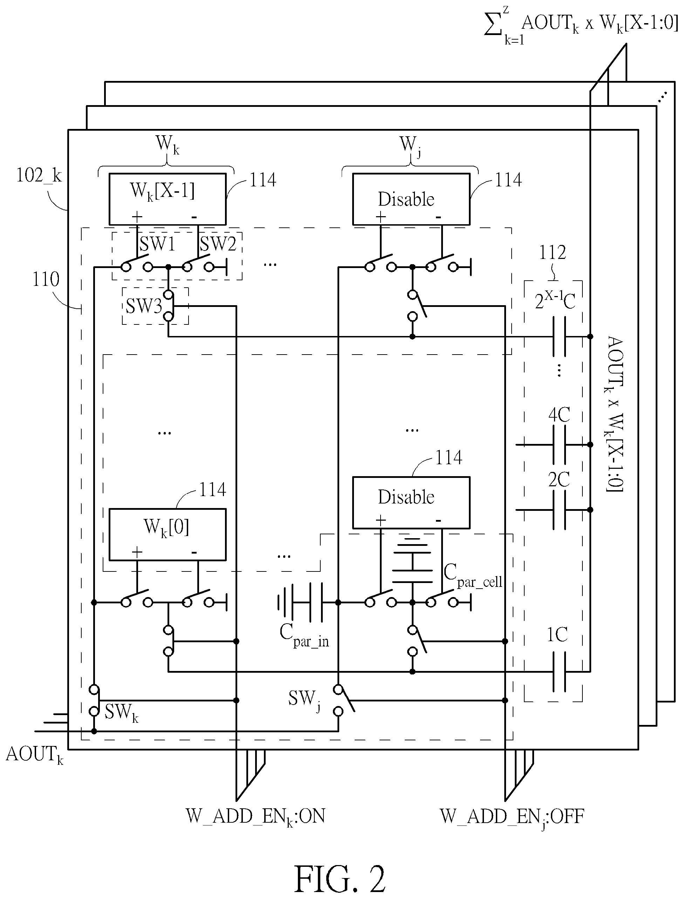

For better comprehension of technical features of the present invention, an exemplary circuit design of a processing circuit used by the proposed CIM circuit 100 is illustrated in FIG. 2. The processing circuit 102_k ($k = \{1, 2, ..., Z\}$) shown in FIG. 2 may be any of the processing circuits 102_1-102_Z shown in FIG. 1. In this embodiment, the candidate weights $CW_1$-$CW_Y$ may be stored in memory cell lines (e.g., memory cell rows or memory cell columns), respectively; and candidate weights included in the candidate weights $CW_1$-$CW_Y$ that are not selected as the target weight $W_k$ used by the processing circuit 102_k are collectively represented by $W_j$. The selection circuit 110 may be a switch-based circuit including a plurality of switches that may be implemented using P-channel metal-oxide-semiconductor (PMOS) transistors or N-channel metal-oxide-semiconductor (NMOS) transistors, and may be integrated with the memory array 108. As shown in FIG. 2, the selection circuit 110 includes a plurality of global selection switches $SW_k$ and $SW_j$, where the global selection switch $SW_k$ corresponds to a candidate weight that is selected as the target weight $W_k$, and the global selection switch $SW_j$ corresponds to any candidate weight that is not selected as the target weight $W_k$. Specifically, the global selection switch $SW_k$ is shared among memory cells that store bits of a candidate weight that is selected as the target weight $W_k$, and the global selection switch $SW_j$ is shared among memory cells that store bits of a candidate weight that is not selected as the target weight $W_k$. In addition, the selection circuit 110 includes a plurality of local selection switches for each memory cell that stores one bit of the candidate weights $CW_1$-$CW_Y$. Taking the memory cell that stores the bit $W_k[X-1]$ for example, there are two weight switches SW1 and SW2 and one cell switch SW3. However, this is for illustrative purposes only, and is not meant to be a limitation of the present invention. In practice, the number of local selection switches for each memory cell may be adjusted, depending upon actual design considerations.

Each of the global selection switches $SW_k$ and $SW_j$ has one terminal that is arranged to receive the analog input $AOUT_k$ from an external analog buffer (not shown). One of the global selection switches that corresponds to a memory cell line (e.g., memory cell row or memory cell column) in which the target weight $W_k$ is stored is switched on, and the rest of the global selection switches are switched off. In this embodiment, one switch control signal $W\_ADD\_EN_k$ may be asserted to switch on the global selection switch $SW_k$, and another switch control signal $W\_ADD\_EN_j$ may be deasserted to switch off the global selection switch $SW_j$. Though the candidate weight $W_j$ is not selected as the target weight $W_k$, the memory cells that store bits of the candidate weight $W_j$

may include input parasitic capacitance $C_{par\_in}$. By switching off the global selection switch $SW_j$, the power dissipation resulting from input parasitic capacitance $C_{par\_in}$ of memory cells that stores bits of the candidate weight $W_j$ can be prevented to achieve energy reduction/power saving.

Suppose that the memory array 108 is an SRAM array, and each of the memory cells 114 is an SRAM cell. Hence, each memory cell 114 may have two bit lines $BL$ and $\overline{BL}$, where a voltage level at the bit line $BL$ (which is labeled by "+" in FIG. 2) is set based on the bit stored in the memory cell 114, and a voltage level at the bit line $BL$ (which is labeled by "-" in FIG. 2) is set based on an inverse of the bit stored in the memory cell 114. Regarding a memory cell that stores one bit of the target weight $W_k$, the weight switches SW1 and SW2 (which are local selection switches of the memory cell) are controlled by the bit stored in the memory cell. Taking the weight switches SW1 and SW2 of the memory cell that stores the bit $W_k$ [X-1] for example, the weight switch SW1 is controlled by the bit $W_k$ [X-1], and the weight switch SW2 is controlled by an inverse of the bit $W_k$ [X-1] (i.e., $\overline{W_k[X-1]}$), where the weight switch SW1 determines whether the analog input $AOUT_k$ (which is received from the switched-on global selection switch $SW_k$) is passed to the charge-domain passive summation circuit (particularly, capacitor $2^{X-1}C$ of weighted capacitor array 112), and the weight switch SW2 determines whether a reference voltage (e.g., ground voltage) is passed to the charge-domain passive summation circuit (particularly, capacitor $2^{X-1}C$ of weighted capacitor array 112). It should be noted that the weight switches SW1 and SW2 are not switched on at the same time. That is, the weight switch SW2 is switched off during a period in which the weight switch SW1 is switched on, and the weight switch SW1 is switched off during a period in which the weight switch SW2 is switched on.

The cell selection switch SW3 is also a local selection switch integrated with each memory cell 114. In this embodiment, the candidate weights $CW_1$-$CW_Y$ may be stored in memory cell lines (e.g., memory cell rows or memory cell columns), respectively. The cell selection switches SW3 integrated with the memory array 108 may be categorized into a plurality of cell selection switch groups that correspond to the memory cell lines (e.g., memory cell rows or memory cell columns), respectively. Hence, each of the cell selection switch groups includes cell selection switches SW3, each having one terminal that is coupled to the charge-domain passive summation circuit (particularly, one capacitor of weighted capacitor array 122). For example, the cell selection switch SW3 of the memory cell that stores the bit $W_k$ [X-1] has one terminal coupled to the capacitor $2^{X-1}C$ of the weighted capacitor array 112, the cell selection switch SW3 of the memory cell that stores the bit $W_k$ [ 0 ] has one terminal coupled to the capacitor 1C of the weighted capacitor array 112, and so on. In this embodiment, cell selection switches of one of the cell selection switch groups that corresponds to a memory cell line (e.g., memory cell row or memory cell column) in which the target weight $W_k$ is stored are switched on, and cell selection switches of the rest of the cell selection switch groups are switched off. For example, cell selection switches SW3 of a cell selection switch group that corresponds to a memory cell line (e.g., memory cell row or memory cell column) in which the candidate weight $W_j$ is stored are switched off. Though the candidate weight $W_j$ is not selected as the target weight $W_k$, the memory cells that store bits of the candidate weight $W_j$ may include cell parasitic capacitance $C_{par\_cell}$. By switching off the cell selection switches SW3, the power dissipation resulting from cell parasitic capacitance $C_{par\_cell}$ of memory cells that stores bits of the candidate weight $W_j$ (which is not selected as the target weight $W_k$) can be prevented to achieve energy reduction/power saving.

As shown in FIG. 1, the external analog buffers (e.g., digital-to-analog converters) 10_1-10_Z generates analog inputs $AOUT_1$-$AOUT_Z$ of the processing circuits 102_1-102_Z, respectively. Ideally, when two digital codes (e.g., $DIN_1$ and $DIN_2$) are the same, the corresponding analog inputs (e.g., $AOUT_1$ and $AOUT_2$) received by the CIM circuit 100 should be the same. However, inter-buffer mismatch may exist between different analog buffers due to imperfection of circuit components. As a result, the output voltage VOUT (which is an analog output of $\sum_{k=1}^{Z} DIN_k \times W_k[X-1:0]$) may deviate from a correct voltage level. In a case where the CIM circuit 100 is used by an AI application, the classification accuracy may be degraded due to the inter-buffer mismatch. To address this issue, the CIM circuit 100 is further involved in calibration of external analog buffers (e.g., digital-to-analog converters) 10_1-10_Z.

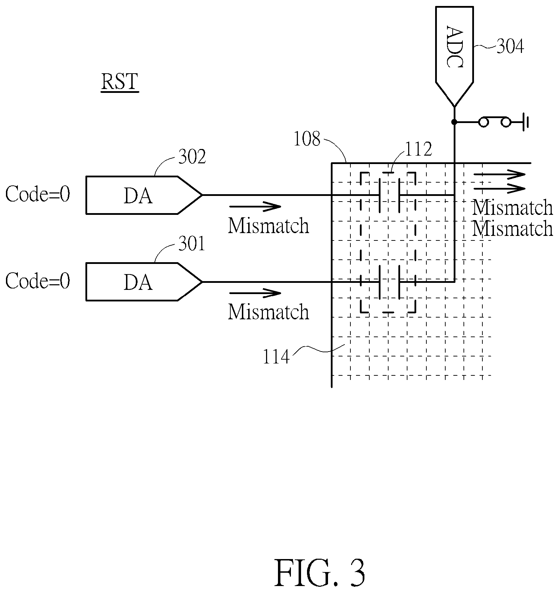

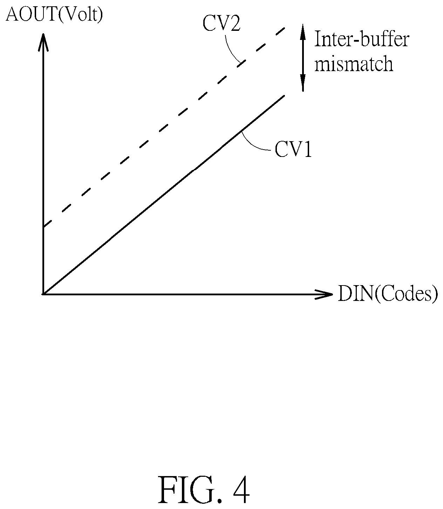

Please refer to FIG. 3 and FIG. 4. FIG. 3 is a diagram illustrating calibration of different external analog buffers of a CIM circuit according to an embodiment of the present invention. FIG. 4 is a diagram illustrating inter-buffer mismatch between different external analog buffers. The external analog buffer 301 may be one of the external analog buffers (e.g., digital-to-analog converters) 10_1-10_Z shown in FIG. 1. The external analog buffer 302 may be another of the external analog buffers (e.g., digital-to-analog converters) 10_1-10_Z shown in FIG. 1. Due to imperfection of circuit components, the transfer curve CV1 of the external analog buffer 301 is different from the transfer curve CV2 of the external analog buffer 302. Hence, the calibration of the external analog buffers 301 and 302 may include cancelling inter-buffer mismatch between the external analog buffers 301 and 302. For example, an auto-zeroing technique may be employed for inter-buffer mismatch cancellation. In some embodiments of the present invention, each of the external analog buffers 301 and 302 may be a discrete-time buffer. The discrete-time operation of the external analog buffer 301/302 may include a first phase in which the external analog buffer 301/302 operates in a reset (RST) mode and a second phase in which the external analog buffer 301/302 operates in a buffer (BUF) mode. The calibration of the external analog buffers 301 and 302 is performed during a period in which both of the external analog buffers 301 and 302 operate in the RST mode. As shown in FIG. 3, the same digital input (e.g., digital code = 0) is fed into both of the external analog buffers 301 and 302, and a ground voltage is applied to top plates of capacitors included in the weighted capacitor array 112. In this way, the inter-buffer mismatch between the external analog buffers 301 and 302 is stored in the weighted capacitor array 112 when the external analog buffers 301 and 302 operate in the RST mode, and can be subtracted from the output voltage VOUT (which is an analog output of $\sum_{k=1}^{Z} DIN_k \times W_k[X-1:0]$)

when the external analog buffers 301 and 302 operate in the BUF mode. Since the inter-buffer mismatch between the external analog buffers 301 and 302 can be cancelled by auto-zeroing, the external analog buffers 301 and 302 may be regarded as having the same transfer curve (i.e., CV1 = CV2) after calibration.

However, it is possible that the same transfer curve possessed by the external analog buffers 301 and 302 after auto-zeroing may still deviate from an ideal curve. To address this issue, the calibration of the external analog buffers 301 and 302 may further include aligning a transfer curve of each of the external analog buffers 301 and 302 with a predetermined curve.

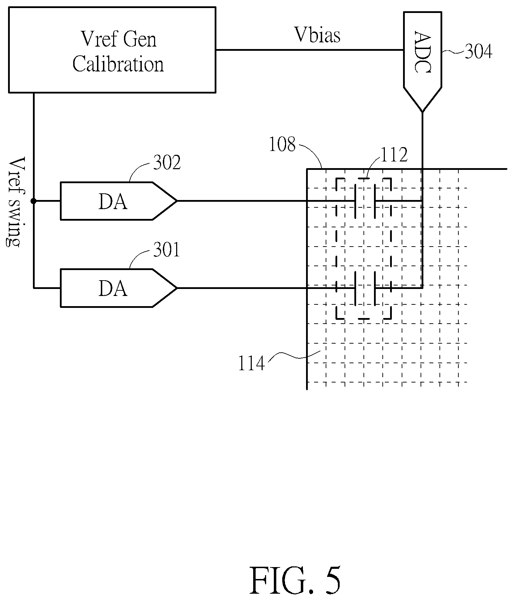

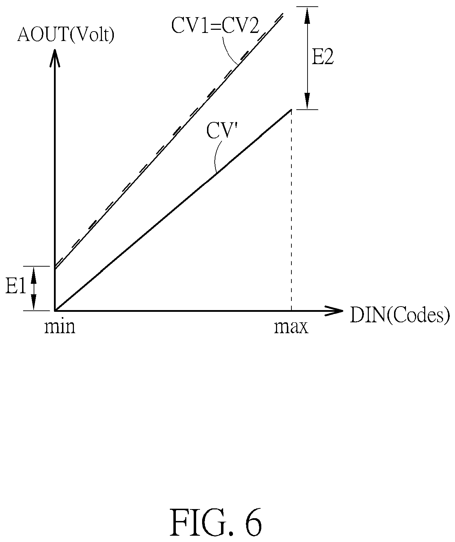

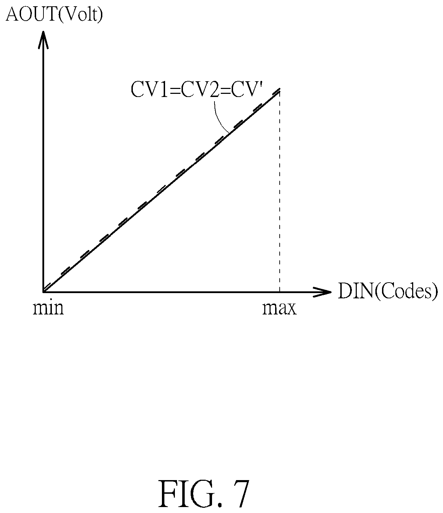

Please refer to FIG. 5, FIG. 6, and FIG. 7. FIG. 5 is a diagram illustrating additional calibration of different external analog buffers of a CIM circuit according to an embodiment of the present invention. FIG. 6 is a diagram illustrating deviation between aligned transfer curves of the external analog buffers 301 and 302 and an ideal curve CV' before reference voltage tuning. FIG. 7 is a diagram illustrating that the aligned transfer curves of the external analog buffers 301 and 302 are the same as the ideal curve CV' after reference voltage tuning. The minimum digital input (e.g., minimum code min) is applied to the external analog buffers 301 and 302, and a global offset E1 is obtained by the ADC 304, where a bias voltage Vbias of the ADC 304 is generated from a reference voltage generator. In addition, the maximum digital input (e.g., maximum code max) is applied to the external analog buffers 301 and 302, and a gain error E2 is obtained by the ADC 304. As shown in FIG. 5, reference voltage generator calibration (labeled by "Vref Gen Calibration") is performed for tuning the reference voltages Vref used by the external analog buffers 301 and 302. In this way, the external analog buffers 301 and 302 can have the same transfer curve (which results from auto-zeroing) aligned with the ideal curve CV' through reference voltage tuning.

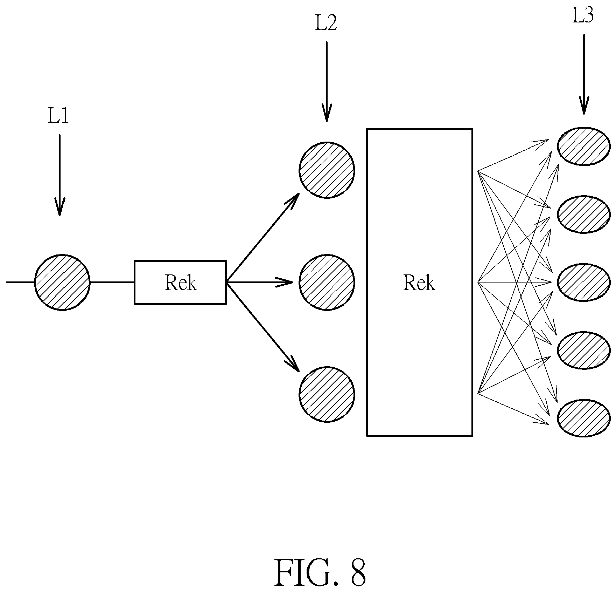

As mentioned above, the proposed CIM circuit 100 may be employed by an AI application. For example, the AI application may employ a CNN with multiple layers, and the proposed CIM circuit 100 may be used by a neuron in one layer and reused by a neuron in another layer. In some embodiments of the present invention, per-layer calibration may be employed for tracking process, voltage, temperature (PVT) variation. FIG. 8 is a diagram illustrating per-layer calibration of different external analog buffers of a CIM circuit according to an embodiment of the present invention. In this embodiment, the neural network includes a plurality of layers such as L1, L2, and L3 shown in FIG. 8. The same CIM circuit 100 may be shared among different layers L1, L2, and L3. The aforementioned calibration (labeled by "ReK") of different external analog buffers (e.g., external analog buffers 301 and 302 shown in FIG. 3 and FIG. 5) is performed per layer, thereby making the external analog buffers 301 and 302 have the same transfer curve aligned with the ideal curve CV'. With the help of the per-layer calibration, a PVT insensitive ACIM circuit can be achieved.

Those skilled in the art will readily observe that numerous modifications and alterations of the device and method may be made while retaining the teachings of the invention. Accordingly, the above disclosure should be construed as limited only by the metes and bounds of the appended claims.

**Claims**

1. A compute-in-memory, CIM, circuit comprising:
   a first processing circuit (102_1-102_z), comprising:

   a first data-selection circuit (104), comprising:

   a first memory array (108), arranged to store a plurality of candidate weights; and
   a first selection circuit (110), arranged to select a first target weight from the plurality of candidate weights stored in the first memory array (108); and

   a first charge-domain passive summation circuit (106), arranged to generate a first analog computation result ($AOUT_k$x$W_k$[X-1:0]) of a first input ($AOUT_k$) received by the first processing circuit (102_1-102_z) and the first target weight ($W_K$[X-1:0]) stored in the first memory array (108) through a first weighted capacitor array (112) integrated with the first memory array (108);
   wherein the first weighted capacitor array (112) of the first charge-domain passive summation circuit (106) comprises a plurality of first capacitors ($C_1$-$C_N$); and the first selection circuit (110) is further arranged to output a plurality of voltage signals ($VIN_1$-$VIN_N$) to the plurality of first capacitors ($C_1$-$C_N$), respectively, according to the first input ($AOUT_k$) and the first target weight ($W_K$[X-1:0]).

**2.** The CIM circuit (100) of claim 1, wherein the plurality of candidate weights are weights of a neural network.

**3.** The CIM circuit (100) of claim 1 or claim 2, wherein the first input of the first processing circuit (102_1-102_z) is a single analog signal generated from an external analog buffer (10_1-10-z, 301, 302).

**4.** The CIM circuit (100) of any one of the preceding claims, wherein the first target weight comprises a plurality of bits, and the plurality of bits are stored in a plurality of memory cells (114) in the memory array (108), respectively.

**5.** The CIM circuit (100) of claim 4, wherein the first selection circuit (110) is further arranged to selectively apply the first input to the plurality of first capacitors according to the plurality of bits, respectively.

**6.** The CIM circuit (100) of claim 5, wherein the first selection circuit (110) is further arranged to control transmission of the first input by referring to the plurality of bits concurrently.

**7.** The CIM circuit (100) of claim 1, further comprising:

a second data-selection circuit (104), comprising:

a second memory array (108), arranged to store the plurality of candidate weights; and a second selection circuit (110), arranged to select a second target weight from the plurality of candidate weights stored in the second memory array (108); and

a second charge-domain passive summation circuit (106), arranged to generate a second analog computation result of a second input received by the second processing circuit (102_1-102_z and the second target weight stored in the second memory array (108) through a second weighted capacitor array (112) integrated with the second memory array (108);
wherein the first weighted capacitor array (112) of the first charge-domain passive summation circuit (106) comprises the plurality of first capacitors each having a first plate and a second plate; the second weighted capacitor array (112) of the second charge-domain passive summation circuit (106) comprises a plurality of second capacitors each having a first plate and a second plate; first plates of the plurality of first capacitors are connected to first plates of the second capacitors; and the second selection circuit (110) is further arranged to output a plurality of voltage signals ($VIN_1$-$VIN_N$) to the plurality of second capacitors ($C_1$-$C_N$), respectively, according to the second input ($AOUT_k$) and the second target weight ($W_k[X-1:0]$).

**8.** The CIM circuit (100) of any one of the preceding claims, wherein the first weighted capacitor array (112) of the first charge-domain passive summation circuit (106) is shared among the plurality of candidate weights stored in the first memory array (108).

**9.** The CIM circuit (100) of any one of the preceding claims, wherein the first memory array (108) comprises a plurality of memory cell lines arranged to store the plurality of candidate weights, respectively, where each of the plurality of memory cell lines comprises a plurality of memory cells (114); the first selection circuit (110) comprises:
a plurality of global selection switches, corresponding to the plurality of memory cell (114) lines, respectively, wherein each of the plurality of global selection switches has one terminal that is arranged to receive the first input and the other terminal selectively coupled to the plurality of first capacitors ($C_1$-$C_N$), and one of the plurality of global selection switches that corresponds to a memory cell (114) line in which the first target weight is stored is switched on.

**10.** The CIM circuit (100) of claim 1, wherein the plurality of memory cells (114) comprise a plurality of first memory cells (114) arranged to store a plurality of bits of the first target weight; and for each of the plurality of bits of the first target weight, the first selection circuit (110) comprises:

a first switch, controlled by the bit, wherein the first switch determines whether the first input is passed to the first charge-domain passive summation circuit (106); and
a second switch, controlled by an inverse of the bit, wherein the second switch determines whether a reference voltage is passed to the first charge-domain passive summation circuit (106).

**11.** The CIM circuit (100) of claim 1, wherein the first memory array (108) comprises a plurality of memory cell (114) lines arranged to store the plurality of candidate weights, respectively; the first selection circuit (110) comprises:
a plurality of cell selection switch groups, corresponding to the plurality of memory cell (114) lines, respectively, wherein each of the plurality of cell selection switch groups comprises cell selection switches, each having one terminal that is coupled to the first charge-domain passive summation circuit (106); and cell selection switches of one of the plurality of cell selection switch groups that corresponds to a memory cell (114) line in which the first target weight is stored are switched on.

12. The CIM circuit (100) of claim 1, further comprising:

a second data-selection circuit (104), comprising:

a second memory array (108), arranged to store the plurality of candidate weights; and a second selection circuit (110), arranged to select a second target weight from the plurality of candidate weights stored in the second memory array (108); and

a second charge-domain passive summation circuit (106), arranged to generate a second analog computation result of a second input received by the second data-selection circuit (104) and the second target weight stored in the second memory array (108) through a second weighted capacitor array (112) integrated with the second memory array (108); wherein the first data-selection circuit (104) receives the first input from a first external analog buffer (10_1-10-z, 301, 302), and the second data-selection circuit (104) receives the second input from a second external analog buffer (10_1-10-z, 301, 302); and wherein the CIM circuit (100) is further involved in calibration of the first external analog buffer (10_1-10-z, 301, 302)and the second external analog buffer (10_1-10-z, 301, 302), and the calibration of the first external analog buffer (10_1-10-z, 301, 302)and the second external analog buffer (10_1-10-z, 301, 302) comprises storing inter-buffer mismatch between the first external analog buffer (10_1-10-z, 301, 302)and the second external analog buffer (10_1-10-z, 301, 302) in the weighted capacitor array (112) of the CIM circuit (100); and wherein the second weighted capacitor array (112) of the second charge-domain passive summation circuit (106) comprises a plurality of second capacitors ($C_1$-$C_N$); and the second selection circuit (110) is further arranged to output a plurality of voltage signals ($VIN_1$-$VIN_N$) to the plurality of second capacitors ($C_1$-$C_N$), respectively, according to the second input ($AOUT_k$) and the second target weight ($W_K$[X-1:0]).

13. The CIM circuit (100) of claim 12, wherein the calibration of the first external analog buffer (10_1-10-z, 301, 302) and the second external analog buffer (10_1-10-z, 301, 302) further comprises cancelling the inter-buffer mismatch between the first external analog buffer (10_1-10-z, 301, 302)and the second external analog buffer (10_1-10-z, 301, 302); or wherein the calibration of the first external analog buffer (10_1-10-z, 301, 302)and the second external analog buffer (10_1-10-z, 301, 302) further comprises aligning a transfer curve of each of the first external analog buffer (10_1-10-z, 301, 302)and the second external analog buffer (10_1-10-z, 301, 302) with a predetermined curve.

14. The CIM circuit (100) of claim 12, wherein a neural network includes a plurality of layers, the CIM circuit (100) is used by each of the plurality of layers, and the calibration of the first external analog buffer (10_1-10-z, 301, 302)and the second external analog buffer (10_1-10-z, 301, 302)is performed per layer.

15. A compute-in-memory, CIM, method applied on a system as defined by any of claims 1-14 comprising:

storing a plurality of candidate weights in a memory array (108);
selecting a target weight from the plurality of candidate weights; and
performing, by a weighted capacitor array (112) integrated with the memory array (108), charge-domain passive summation to generate an analog computation result of an input and the target weight.

**Patentansprüche**

1. Rechnen-in-Speicher(compute-in-memory, CIM)-Schaltung, umfassend:
eine erste Verarbeitungsschaltung (102_1-102_z), umfassend:
eine erste Datenauswahlschaltung (104), umfassend:

ein erstes Speicherarray (108), das angeordnet ist, um eine Vielzahl von Kandidatengewichten zu speichern; und
eine erste Auswahlschaltung (110), die angeordnet ist, um ein erstes Zielgewicht aus der Vielzahl von in dem ersten Speicherarray (108) gespeicherten Kandidatengewichten auszuwählen; und
eine erste passive Ladungsdomänensummierungsschaltung (106), die angeordnet ist, um ein erstes analoges Berechnungsergebnis ($AAUS_k$x$W_K$[X-1:0]) einer von der ersten Verarbeitungsschaltung (102_1-102_z) empfangenen ersten Eingabe ($AAUS_k$) und des in dem ersten Speicherarray (108) gespeicherten ersten Zielgewichts ($W_K$[X-1:0]) durch ein mit dem ersten Speicherarray (108) integriertes erstes gewichtetes Kondensatorarray (112) zu erzeugen;

wobei das erste gewichtete Kondensatorarray (112) der ersten passiven Ladungsdomänensummmierungsschaltung (106) eine Vielzahl von ersten Kondensatoren ($C_1$-$C_N$) umfasst; und die erste Auswahlschaltung (110) ferner angeordnet ist, um eine Vielzahl von Spannungssignalen ($VEIN_1$-$VEIN_N$) an die Vielzahl von ersten Kondensatoren ($C_1$-$C_N$) jeweils gemäß der ersten Eingabe ($AAUS_k$) und dem ersten Zielgewicht ($W_K[X-1:0]$) auszugeben.

2. CIM-Schaltung (100) nach Anspruch 1, wobei die Vielzahl von Kandidatengewichten Gewichte eines neuronalen Netzwerks sind.

3. CIM-Schaltung (100) nach Anspruch 1 oder Anspruch 2, wobei die erste Eingabe der ersten Verarbeitungsschaltung (102_1-102_z) ein von einem externen Analogpuffer (10_1-10-z, 301, 302) erzeugtes einzelnes Analogsignal ist.

4. CIM-Schaltung (100) nach einem der vorhergehenden Ansprüche, wobei das erste Zielgewicht eine Vielzahl von Bits umfasst und die Vielzahl von Bits jeweils in einer Vielzahl von Speicherzellen (114) in dem Speicherarray (108) gespeichert sind.

5. CIM-Schaltung (100) nach Anspruch 4, wobei die erste Auswahlschaltung (110) ferner angeordnet ist, um die erste Eingabe gemäß der Vielzahl von Bits jeweils selektiv an die Vielzahl von ersten Kondensatoren anzulegen.

6. CIM-Schaltung (100) nach Anspruch 5, wobei die erste Auswahlschaltung (110) ferner angeordnet ist, um eine Übertragung der ersten Eingabe durch gleichzeitiges Beziehen auf die Vielzahl von Bits zu steuern.

7. CIM-Schaltung (100) nach Anspruch 1, ferner umfassend:

eine zweite Datenauswahlschaltung (104), umfassend:

ein zweites Speicherarray (108), das angeordnet ist, um die Vielzahl von Kandidatengewichten zu speichern; und
eine zweite Auswahlschaltung (110), die angeordnet ist, um ein zweites Zielgewicht aus der Vielzahl von in dem zweiten Speicherarray (108) gespeicherten Kandidatengewichten auszuwählen; und
eine zweite passive Ladungsdomänensummmierungsschaltung (106), die angeordnet ist, um ein zweites analoges Berechnungsergebnis einer von der zweiten Verarbeitungsschaltung (102_1-102_z empfangenen zweiten Eingabe und des in dem zweiten Speicherarray (108) gespeicherten zweiten Zielgewichts durch ein mit dem zweiten Speicherarray (108) integriertes zweites gewichtetes Kondensatorarray (112) zu erzeugen;

wobei das erste gewichtete Kondensatorarray (112) der ersten passiven Ladungsdomänensummmierungsschaltung (106) die Vielzahl von ersten Kondensatoren umfasst, die jeweils eine erste Platte und eine zweite Platte aufweisen; das zweite gewichtete Kondensatorarray (112) der zweiten passiven Ladungsdomänensummmierungsschaltung (106) eine Vielzahl von zweiten Kondensatoren umfasst, die jeweils eine erste Platte und eine zweite Platte aufweisen; erste Platten der Vielzahl von ersten Kondensatoren mit ersten Platten der zweiten Kondensatoren verbunden sind; und die zweite Auswahlschaltung (110) ferner angeordnet ist, um eine Vielzahl von Spannungssignalen ($VEIN_1$-$VEIN_N$) an die Vielzahl von zweiten Kondensatoren ($C_1$-$C_N$) jeweils gemäß der zweiten Eingabe ($AAUS_k$) und dem zweiten Zielgewicht ($W_K[X-1:0]$) auszugeben.

8. CIM-Schaltung (100) nach einem der vorhergehenden Ansprüche, wobei das erste gewichtete Kondensatorarray (112) der ersten passiven Ladungsdomänensummmierungsschaltung (106) unter der Vielzahl von in dem ersten Speicherarray (108) gespeicherten Kandidatengewichten gemeinsam genutzt ist.

9. CIM-Schaltung (100) nach einem der vorhergehenden Ansprüche, wobei das erste Speicherarray (108) eine Vielzahl von Speicherzellen-Zeilen umfasst, die angeordnet sind, um jeweils die Vielzahl von Kandidatengewichten zu speichern, wobei jede der Vielzahl von Speicherzellen-Zeilen eine Vielzahl von Speicherzellen (114) umfasst; die erste Auswahlschaltung (110) Folgendes umfasst:
eine Vielzahl von globalen Auswahlschaltern, die jeweils der Vielzahl von Speicherzellen(114)-Zeilen entsprechen, wobei jeder der Vielzahl von globalen Auswahlschaltern einen Anschluss aufweist, der angeordnet ist, um die erste Eingabe zu empfangen, und der andere Anschluss selektiv mit der Vielzahl von ersten Kondensatoren ($C_1$-$C_N$) gekoppelt ist und einer der Vielzahl von globalen Auswahlschaltern, der einer Speicherzellen(114)-Zeile entspricht, in der das erste Zielgewicht gespeichert ist, eingeschaltet ist.

10. CIM-Schaltung (100) nach Anspruch 1, wobei die Vielzahl von Speicherzellen (114) eine Vielzahl von ersten Speicherzellen (114) umfassen, die angeordnet sind, um eine Vielzahl von Bits des ersten Zielgewichts zu speichern; und die erste Auswahlschaltung (110) für jedes der Vielzahl von Bits des ersten Zielgewichts Folgendes umfasst:

> einen durch das Bit gesteuerten ersten Schalter, wobei der erste Schalter bestimmt, ob die erste Eingabe an die erste passive Ladungsdomänensummmierungsschaltung (106) weitergeleitet wird; und
> einen durch eine Inverse des Bits gesteuerten zweiten Schalter, wobei der zweite Schalter bestimmt, ob eine Referenzspannung an die erste passive Ladungsdomänensummmierungsschaltung (106) weitergeleitet wird.

11. CIM-Schaltung (100) nach Anspruch 1, wobei das erste Speicherarray (108) eine Vielzahl von Speicherzellen(114)-Zeilen umfasst, die angeordnet sind, um jeweils die Vielzahl von Kandidatengewichten zu speichern; die erste Auswahlschaltung (110) Folgendes umfasst:
eine Vielzahl von Zellauswahlschaltergruppen, die jeweils der Vielzahl von Speicherzellen(114)-Zeilen entsprechen, wobei jede der Vielzahl von Zellauswahlschaltergruppen Zellauswahlschalter umfasst, die jeweils einen Anschluss aufweisen, der mit der ersten passiven Ladungsdomänensummmierungsschaltung (106) gekoppelt ist; und Zellauswahlschalter einer der Vielzahl von Zellauswahlschaltergruppen, die einer Speicherzellen(114)-Zeile entspricht, in der das erste Zielgewicht gespeichert ist, eingeschaltet sind.

12. CIM-Schaltung (100) nach Anspruch 1, ferner umfassend:
eine zweite Datenauswahlschaltung (104), umfassend:

> ein zweites Speicherarray (108), das angeordnet ist, um die Vielzahl von Kandidatengewichten zu speichern; und
> eine zweite Auswahlschaltung (110), die angeordnet ist, um ein zweites Zielgewicht aus der Vielzahl von in dem zweiten Speicherarray (108) gespeicherten Kandidatengewichten auszuwählen; und
> eine zweite passive Ladungsdomänensummmierungsschaltung (106), die angeordnet ist, um ein zweites analoges Berechnungsergebnis einer von der zweiten Datenauswahlschaltung (104) empfangenen zweiten Eingabe und des in dem zweiten Speicherarray (108) gespeicherten zweiten Zielgewichts durch ein mit dem zweiten Speicherarray (108) integriertes zweites gewichtetes Kondensatorarray (112) zu erzeugen;
> wobei die erste Datenauswahlschaltung (104) die erste Eingabe von einem ersten externen Analogpuffer (10_1-10-z, 301, 302) empfängt und die zweite Datenauswahlschaltung (104) die zweite Eingabe von einem zweiten externen Analogpuffer (10_1-10-z, 301, 302) empfängt; und

wobei die CIM-Schaltung (100) ferner an einer Kalibrierung des ersten externen Analogpuffers (10_1-10-z, 301, 302) und des zweiten externen Analogpuffers (10_1-10-z, 301, 302) beteiligt ist und die Kalibrierung des ersten externen Analogpuffers (10_1-10-z, 301, 302) und des zweiten externen Analogpuffers (10_1-10-z, 301, 302) ein Speichern einer Zwischenpufferfehlanpassung zwischen dem ersten externen Analogpuffer (10_1-10-z, 301, 302) und dem zweiten externen Analogpuffer (10_1-10-z, 301, 302) in dem gewichteten Kondensatorarray (112) der CIM-Schaltung (100) umfasst; und
wobei das zweite gewichtete Kondensatorarray (112) der zweiten passiven Ladungsdomänensummmierungsschaltung (106) eine Vielzahl von zweiten Kondensatoren ($C_1$-$C_N$) umfasst; und die zweite Auswahlschaltung (110) ferner angeordnet ist, um eine Vielzahl von Spannungssignalen ($VEIN_1$-$VEIN_N$) an die Vielzahl von zweiten Kondensatoren ($C_1$-$C_N$) jeweils gemäß der zweiten Eingabe ($AAUS_k$) und dem zweiten Zielgewicht ($W_k[X-1:0]$) auszugeben.

13. CIM-Schaltung (100) nach Anspruch 12, wobei die Kalibrierung des ersten externen Analogpuffers (10_1-10-z, 301, 302) und des zweiten externen Analogpuffers (10_1-10-z, 301, 302) ferner ein Aufheben der Zwischenpufferfehlanpassung zwischen dem ersten externen Analogpuffer (10_1-10-z, 301, 302) und dem zweiten externen Analogpuffer (10_1-10-z, 301, 302) umfasst; oder
wobei die Kalibrierung des ersten externen Analogpuffers (10_1-10-z, 301, 302) und des zweiten externen Analogpuffers (10_1-10-z, 301, 302) ferner ein Ausrichten einer Übertragungskurve jedes des ersten externen Analogpuffers (10_1-10-z, 301, 302) und des zweiten externen Analogpuffers (10_1-10-z, 301, 302) an einer vorbestimmten Kurve umfasst.

14. CIM-Schaltung (100) nach Anspruch 12, wobei ein neuronales Netzwerk eine Vielzahl von Schichten beinhaltet, die CIM-Schaltung (100) von jeder der Vielzahl von Schichten verwendet wird und die Kalibrierung des ersten externen Analogpuffers (10_1-10-z, 301, 302) und des zweiten externen Analogpuffers (10_1-10-z, 301, 302) pro Schicht durchgeführt wird.

15. Rechnen-in-Speicher(CIM)-Verfahren, das auf ein System nach einem der Ansprüche 1 bis 14 angewendet wird, umfassend:

Speichern einer Vielzahl von Kandidatengewichten in einem Speicherarray (108);

Auswählen eines Zielgewichts aus der Vielzahl von Kandidatengewichten; und

Durchführen einer passiven Ladungsdomänensummierung durch ein mit dem Speicherarray (108) integriertes gewichtetes Kondensatorarray (112), um ein analoges Berechnungsergebnis einer Eingabe und des Zielgewichts zu erzeugen.

**Revendications**

1. Circuit de calcul en mémoire (CIM) comprenant :
un premier circuit de traitement (102_1-102_z), comprenant :
un premier circuit de sélection de données (104), comprenant :

un premier réseau de mémoire (108), conçu pour stocker une pluralité de poids candidats ; et
un premier circuit de sélection (110), conçu pour sélectionner un premier poids cible parmi la pluralité de poids candidats stockés dans le premier réseau de mémoire (108) ; et
un premier circuit de sommation passif en domaine de charge (106), conçu pour générer un premier résultat de calcul analogique ($AOUT_k \times W_K[X-1:0]$) d'une première entrée ($AOUT_k$) reçue par le premier circuit de traitement (102_1-102_z) et le premier poids cible ($W_K[X-1:0]$) stocké dans le premier réseau de mémoire (108) via un premier réseau de condensateurs pondérés (112) intégré au premier réseau de mémoire (108) ;
dans lequel le premier réseau de condensateurs pondérés (112) du premier circuit de sommation passif en domaine de charge (106) comprend une pluralité de premiers condensateurs ($C_1$-$C_N$) ;
et le premier circuit de sélection (110) est également conçu pour produire une pluralité de signaux de tension ($VIN_1$-$VIN_N$) vers la pluralité de premiers condensateurs ($C_1$-$C_N$), respectivement, selon la première entrée ($AOUT_k$) et le premier poids cible ($W_K[X-1:0]$).

2. Circuit CIM (100) selon la revendication 1, dans lequel la pluralité de poids candidats sont des poids d'un réseau neuronal.

3. Circuit CIM (100) selon la revendication 1 ou la revendication 2, dans lequel la première entrée du premier circuit de traitement (102_1-102_z) est un signal analogique unique généré à partir d'un tampon analogique externe (10_1-10-z, 301, 302).

4. Circuit CIM (100) selon l'une quelconque des revendications précédentes, dans lequel le premier poids cible comprend une pluralité de bits, et la pluralité de bits sont stockés dans une pluralité de cellules de mémoire (114) dans le réseau de mémoire (108), respectivement.

5. Circuit CIM (100) selon la revendication 4, dans lequel le premier circuit de sélection (110) est également conçu pour appliquer sélectivement la première entrée à la pluralité de premiers condensateurs en fonction de la pluralité de bits, respectivement.

6. Circuit CIM (100) selon la revendication 5, dans lequel le premier circuit de sélection (110) est également conçu pour contrôler la transmission de la première entrée en se référant simultanément à la pluralité de bits.

7. Circuit CIM (100) selon la revendication 1, comprenant également :
un second circuit de sélection de données (104), comprenant :

un second réseau de mémoire (108), conçu pour stocker la pluralité de poids candidats ; et
un second circuit de sélection (110), conçu pour sélectionner un second poids cible parmi la pluralité de poids candidats stockés dans le second réseau de mémoire (108) ; et
un second circuit de sommation passif en domaine de charge (106), conçu pour générer un second résultat de calcul analogique d'une seconde entrée reçue par le second circuit de traitement (102_1-102_z) et le second poids cible stocké dans le second réseau de mémoire (108) via un second réseau de condensateurs pondérés (112) intégré au second réseau de mémoire (108) ;
dans lequel le premier réseau de condensateurs pondérés (112) du premier circuit de sommation passif en domaine de charge (106) comprend la pluralité de premiers condensateurs ayant chacun une première plaque et une seconde plaque ; le second réseau de condensateurs pondérés (112) du second circuit de sommation passif en domaine de charge (106) comprend une pluralité de seconds condensateurs ayant chacun une première plaque et une seconde plaque ; les premières plaques de la pluralité de premiers condensateurs sont connectées aux premières plaques des seconds condensateurs ; et le second circuit de sélection (110) est également conçu pour produire une pluralité de signaux de tension ($VIN_1$-$VIN_N$) vers la pluralité de seconds condensateurs ($C_1$-$C_N$), respectivement, selon la seconde entrée ($AOUT_k$)

et le second poids cible ($W_K[X-1:0]$).

8. Circuit CIM (100) selon l'une quelconque des revendications précédentes, dans lequel le premier réseau de condensateurs pondérés (112) du premier circuit de sommation passive en domaine de charge (106) est partagé entre la pluralité de poids candidats stockés dans le premier réseau de mémoire (108).

9. Circuit CIM (100) selon l'une quelconque des revendications précédentes, dans lequel le premier réseau de mémoire (108) comprend une pluralité de lignes de cellules de mémoire conçues pour stocker respectivement la pluralité de poids candidats, où chacune de la pluralité de lignes de cellules de mémoire comprend une pluralité de cellules de mémoire (114) ; le premier circuit de sélection (110) comprend :

une pluralité de commutateurs de sélection globaux, correspondant respectivement à la pluralité de lignes de cellules de mémoire (114), dans lequel chacun de la pluralité de commutateurs de sélection globaux a une borne conçue pour recevoir la première entrée et l'autre borne couplée sélectivement à la pluralité de premiers condensateurs ($C_1$-$C_N$), et l'un de la pluralité de commutateurs de sélection globaux qui correspond à une ligne de cellules de mémoire (114) dans laquelle le premier poids cible est stocké est activé.

10. Circuit CIM (100) selon la revendication 1, dans lequel la pluralité de cellules de mémoire (114) comprend une pluralité de premières cellules de mémoire (114) conçues pour stocker une pluralité de bits du premier poids cible ; et pour chacun de la pluralité de bits du premier poids cible, le premier circuit de sélection (110) comprend :

un premier commutateur, commandé par le bit, dans lequel le premier commutateur détermine si la première entrée est transmise au premier circuit de sommation passif en domaine de charge (106) ; et
un second commutateur, commandé par un inverse de bit, dans lequel le second commutateur détermine si une tension de référence est transmise au premier circuit de sommation passif en domaine de charge (106).

11. Circuit CIM (100) selon la revendication 1, dans lequel le premier réseau de mémoire (108) comprend une pluralité de lignes de cellules de mémoire (114) conçues pour stocker respectivement la pluralité de poids candidats ; le premier circuit de sélection (110) comprend :
une pluralité de groupes de commutateurs de sélection de cellule, correspondant respectivement à la pluralité de lignes de cellules de mémoire (114), dans lequel chacun de la pluralité de groupes de commutateurs de sélection de cellule comprend des commutateurs de sélection de cellule, chacun ayant une borne qui est couplée au premier circuit de sommation passive en domaine de charge (106) ; et des commutateurs de sélection de cellule de l'un de la pluralité de groupes de commutateurs de sélection de cellule qui correspond à une ligne de cellules de mémoire (114) dans laquelle le premier poids cible est stocké sont activés.

12. Circuit CIM (100) selon la revendication 1, comprenant également :
un second circuit de sélection de données (104), comprenant :

un second réseau de mémoire (108), conçu pour stocker la pluralité de poids candidats ; et
un second circuit de sélection (110), conçu pour sélectionner un second poids cible parmi la pluralité de poids candidats stockés dans le second réseau de mémoire (108) ; et
un second circuit de sommation passif en domaine de charge (106), conçu pour générer un second résultat de calcul analogique d'une seconde entrée reçue par le second circuit de sélection de données (104) et le second poids cible stocké dans le second réseau de mémoire (108) via un second réseau de condensateurs pondérés (112) intégré au second réseau de mémoire (108) ;
dans lequel le premier circuit de sélection de données (104) reçoit la première entrée d'un premier tampon analogique externe (10_1-10-z, 301, 302), et le second circuit de sélection de données (104) reçoit la seconde entrée d'un second tampon analogique externe (10_1-10-z, 301, 302) ; et
dans lequel le circuit CIM (100) est également impliqué dans l'étalonnage du premier tampon analogique externe (10_1-10-z, 301, 302) et du second tampon analogique externe (10_1-10-z, 301, 302), et l'étalonnage du premier tampon analogique externe (10_1-10-z, 301, 302) et du second tampon analogique externe (10_1-10-z, 301, 302) comprend le stockage du désaccord intertampon entre le premier tampon analogique externe (10_1-10-z, 301, 302) et le second tampon analogique externe (10_1-10-z, 301, 302) dans le réseau de condensateurs pondérés (112) du circuit CIM (100) ; et
dans lequel le second réseau de condensateurs pondérés (112) du second circuit de sommation passif en domaine de charge (106) comprend une pluralité de seconds condensateurs ($C_1$-$C_N$) ; et le second circuit de sélection (110) est également conçu pour produire une pluralité de signaux de tension (VIN$_1$-VIN$_N$) vers la pluralité de seconds condensateurs (C$_1$-C$_N$), respectivement, selon la seconde entrée (AOUT$_k$) et le premier poids cible (W$_K$[X-1:0]).

13. Circuit CIM (100) selon la revendication 12, dans lequel l'étalonnage du premier tampon analogique externe (10_1-10-z, 301, 302) et du second tampon analogique externe (10_1-10-z, 301, 302) comprend également l'annulation du désaccord intertampon entre le premier tampon analogique externe (10_1-10-z, 301, 302) et le second tampon analogique externe (10_1-10-z, 301, 302) ; ou dans lequel l'étalonnage du premier tampon analogique externe (10_1-10-z, 301, 302) et du second tampon analogique externe (10_1-10-z, 301, 302) comprend également l'alignement d'une courbe de transfert de chacun du premier tampon analogique externe (10_1-10-z, 301, 302) et du second tampon analogique externe (10_1-10-z, 301, 302) avec une courbe prédéterminée.

14. Circuit CIM (100) selon la revendication 12, dans lequel un réseau neuronal comporte une pluralité de couches, le circuit CIM (100) est utilisé par chacune de la pluralité de couches, et l'étalonnage du premier tampon analogique externe (10_1-10-z, 301, 302) et du second tampon analogique externe (10_1-10-z, 301, 302) est réalisé par couche.

15. Procédé de calcul en mémoire (CIM) appliquée à un système tel que défini par l'une quelconque des revendications 1 à 14, comprenant :

le stockage d'une pluralité de poids candidats dans un réseau de mémoire (108) ;
la sélection d'un poids cible parmi la pluralité de poids candidats ; et
la réalisation, par un réseau de condensateurs pondérés (112) intégré au réseau de mémoire (108), d'une sommation passive en domaine de charge pour générer un résultat de calcul analogique d'une entrée et du poids cible.

FIG. 1

FIG. 2

FIG. 3

FIG. 4

FIG. 5

FIG. 6

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63369673
- US 63369674

- US 20220012016 A1